# EUROPEAN PATENT SPECIFICATION

(11) **EP 1 965 491 B1**
(45) Date of publication and mention of the grant of the patent: **10.12.2008**
(21) Application number: 07425123.2
(22) Date of filing: 02.03.2007
(51) Int. Cl.: H03G 3/30

(54) **Radio frequency power control circuit**
Hochfrequenz-Steuerschaltung
Circuit de commande de puissance d'un signal radiofréquence

(43) Date of publication of application: 03.09.2008
(73) Proprietor: SIAE Microelettronica S.p.A., 20093 Cologno M. MI (IT)
(72) Inventor: Manfredi, Leopoldo, 20128 Milano (IT); Arosio, Diego, 20057 Vimercate (Milano) (IT)
(74) Representative: Gatti, Enrico

(56) References cited:
- EP-A1- 1 427 117
- EP-A2- 1 237 297
- GB-A- 2 368 737

## Description

The present invention relates to a radio frequency power control circuit, used for example in automatic transmit power control (ATPC). More in particular, it relates to an efficient method to extend the dynamic range of the level detectors associated with M-QAM modulated signals.

The present invention can be also applied to other modulations, excluding the constant envelope modulations.

It is common practice to monitor the transmitted power of microwave radios by means of a detector diode coupled to the transmitter output line.

When the transmitted carrier exceeds the threshold of the diode, a DC voltage related to the amplitude of the carrier appears at the output of the diode. Depending on the circuit used, this voltage may be related to the mean value or to the peak of the transmitted power signal.

The signal coupling is conveniently obtained by means of directional structures (both lumped or distributed) to minimize detection errors originated by load mismatch.

Due to the threshold of the diode and to the intrinsic instability of the detected voltage at low signal level, the coupling value must be high, increasing loss on the transmitted signal.

The detected DC voltage is normally used in feed-back loops, and usually applied to amplifiers, for maintaining the transmitted power constant despite gain variations of the transmitter chain. The dynamic range that can be usually reached is about 10 dB.

In modern DMR (Digital Microwave Radio), it is normally required that the transmitted power must be adjusted over a wide dynamic range of more than 40 dB, to comply with ATPC functionality and to perform automatic fade margin test on site. This range, if also high stability and accuracy are required, is quite impossible with conventional circuitry. A prior art gain control circuit can be found in EP-A-1 427 117.

An object of the present invention is therefore to provide a radio frequency power control circuit in which the above disadvantages are eliminated.

A further object of the present invention is to provide a simple circuit with a wide dynamic range.

These and further objects are attained according to the present invention by a radio frequency power control circuit comprising: a variable gain amplifier chain to provide a modulated radio frequency power; an amplitude detector coupled to said variable gain amplifier chain; a controller device receiving a detected signal from said amplitude detector and setting the gain of said variable gain amplifier chain; characterized in that said amplitude detector provides said detected signal to a band pass filter; the signal at the output of said band pass filter is provided to a logarithmic envelope detector; the signal at the output of said logarithmic envelope detector is coupled to an adder; the signal at the output of said amplitude detector is coupled to said adder; the signal at the output of said adder is coupled to said controller device.

Further characteristics of the invention are described in the dependent claims.

According to the present invention such a wide dynamic range is attained by means of residual amplitude modulation detection. This residual amplitude modulation, generated by the modulation process, has a peak envelope value proportional to the transmitted carrier level through pre-defined coefficients specific for each modulation scheme. The frequency of the envelope is also pre-defined as a function of transmission capacity and modulator constellation (modulation scheme). The use of the weighting coefficients make easier correlate the actual peak envelope value to the transmitter carrier.

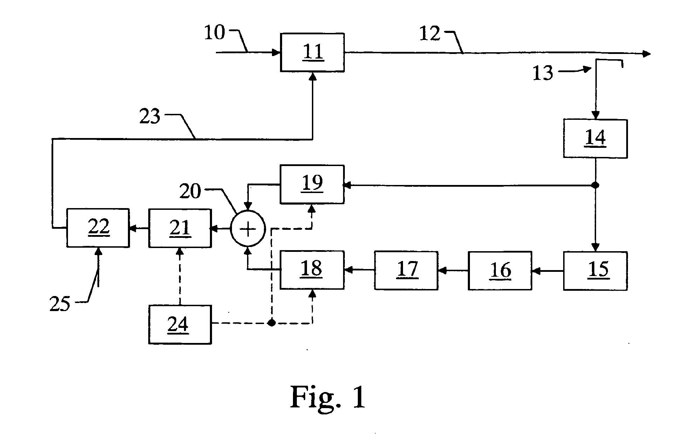

The characteristics and advantages of the present invention will be apparent from the ensuing description of a practical embodiment thereof, illustrated by way of nonlimiting example in the accompanying drawing, in which Figure 1 is a schematic view of a radio frequency power control circuit according to the invention.

Referring to figure 1 a radio frequency power control circuit according to the invention comprises a variable gain amplifier 11, receiving a RF modulated signal from the input terminal 10, and providing the amplified signal to the output terminal 12. It is shown a variable gain amplifier 11, but as it is usual, this amplifier can be substituted by one or more fixed gain amplifiers and one or more variable attenuators.

A coupler 13, preferably directional, picks up the signal available at the output terminal 12, that is sent to an amplitude detector 14, preferably thermally compensated. The amplitude detector 14 is connected to a band pass filter 15. Its output is connected to a logarithmic amplifier 16. The output of the logarithmic amplifier 16 is connected to an envelope detector 17. Its output is connected to a first multiplier 18 for multiplying the input signal with a first weighting coefficient K1. The output of first multiplier 18 is connected to an adder 20.

The logarithmic amplifier 16 and the envelope detector 17, are shown as two separated blocks, for the sake of description, but they could be combined as for example using a logarithmic detector.

The amplitude detector 14 is also connected to a second multiplier 19 for multiplying the input signal with a second weighting coefficient K2. The output of the second multiplier 19 is connected to the adder 20.

The output of the adder 20 is connected to a third multiplier 21 for multiplying its input signal with a third weighting coefficient K3. The output of the third multiplier 21 is connected to a controller device 22. Its output is connected to the variable gain amplifier 11 , in order to vary its gain.

The controller device 22 receives from the terminal 25 the necessary data to obtain the wanted output power.

The radio frequency power control circuit comprises also a memory 24 for memorizing the coefficients K1, K2 and K3. The memory 24 can be implemented in analogue or digital way.

According to an embodiment of the present invention, the signal after the coupler 13 is sent to the amplitude detector 14, that is a diode detecting circuit, which generates a DC voltage proportional to the transmitted signal peak value to be sent to the second multiplier 19. At the same time extracts the residual modulation envelope, by means of the band pass filter 15.

The bandwidth of the band pass filter 15 has to be such that only the band of the modulation envelope is transferred leaving enough attenuation to harmonics and spurious. '

This residual modulation envelope is AC connected to a wideband logarithmic amplifier 16, which extends to at least 50 dB the dynamic range of the microwave detector.

The peak envelope detector 17 after the log amplifier 16 generates a DC signal.

Both the signal coming from the amplitude detector 14 and the signal coming from the envelope detector 17 are weighted by coefficients K1 and K2, respectively, and added together. Then, the signal is weighted by coefficient K3, before entering the controller device 22.

The controller device 22 m-akes up the output power control function by acting on the variable gain (11) of the transmitter chain.

The auxiliary line incorporating coefficient K2 is added to take care of transient conditions where the microwave amplifier is driven into saturation, or in case of non modulated carrier test operations.

In all above mentioned conditions the AC coupled signal is missing so that only the auxiliary line incorporating coefficient K2 can maintain the control alive.

Coefficients K1, K2 and K3, are related to transmitter power level, power am-plifier non linearity characteristic, modulation status (non modulated carrier) and to the modulation scheme (transmission capacity and modulation constellation).

The value of the coefficients K1, K2 and K3 can be for example established by means of experimental tests.

The radio frequency power control circuit here above described can be implemented in analogue or in partial or full digital arrangement, inclusive of relevant D/A and

A/D converters, for single or multiple controlling ports of the variable gain amplifier chain.

## Claims

1. A radio frequency power control circuit comprising:
a variable gain amplifier chain (11) to provide a modulated radio frequency power;
an amplitude detector (14) coupled to said variable gain amplifier chain (11),
a controller device (22) receiving a detected signal from said amplitude detector (14) and setting the gain of said variable gain amplifier chain (11);
**characterized in that**
said amplitude detector (14) provides said detected signal to a band pass filter (15);
the signal at the output of said band pass filter is provided to a logarithmic envelope detector (16, 17);
the signal at the output of said logarithmic envelope detector (16, 17) is coupled to an adder (20),
the signal at the output of said amplitude detector (14) is coupled to said adder (20);
the signal at the output of said adder (20) is coupled to said controller device (22).

2. A radio frequency power control circuit as claimed in claim 1, **characterized in that** said signal at the output of said logarithmic envelope detector is provided to a first multiplier for multiplying it for a first weighting coefficient, before of coupling it to said adder.

3. A radio frequency power control circuit as claimed in claim 1, **characterized in that** said signal at the output of said amplitude detector is provided to a second multiplier for multiplying it for a second weighting coefficient, before of coupling it to said adder.

4. A radio frequency power control circuit as claimed in claim 1, **characterized in that** said signal at the output of said adder is provided to a third multiplier for multiplying it for a third weighting coefficient, before of coupling it to said controller device.

5. A radio frequency power control circuit as claimed in claims 2, 3 e 4 **characterized in that** a memory is provided for memorizing said first, second and third coefficient.

6. A radio frequency power control circuit as claimed in claim 1, **characterized in that** said logarithmic envelope detector comprises a logarithmic amplifier and a second envelope detector.

7. A radio frequency power control circuit as claimed in claim 1, **characterized in that** the controller device is provided with an input port to receive the necessary data to obtain the wanted output power.

## Patentansprüche

1. Hochfrequenz-Leistungssteuerungsschaltung, umfassend:
eine Verstärker-Kette (11) mit variabler Verstärkung zum Bereitstellen einer modulierten Hochfrequenzleistung;
einen Amplitudendetektor (14), der mit der Verstärker-Kette (11) mit variabler Verstärkung gekoppelt ist;
eine Steuerungsvorrichtung (22), die von dem Amplitudendetektor (14) ein erfasstes Signal empfängt und die Verstärkung der Verstärker-Kette (11) mit variabler Verstärkung einstellt;
**dadurch gekennzeichnet, dass**
der Amplitudendetektor (14) das erfasste Signal an ein Bandpassfilter (15) liefert;
das Signal am Ausgang des Bandpassfilters an einen logarithmischen Hüllkurvendetektor (16, 17) geliefert wird;
das Signal am Ausgang des logarithmischen Hüllkurvendetektors (16, 17) an einen Addierer (20) gekoppelt wird;
das Signal am Ausgang des Amplitudendetektors (14) an den Addierer (20) gekoppelt wird;
das Signal am Ausgang des Addierers (20) an die Steuerungsvorrichtung (22) gekoppelt wird.

2. Hochfrequenz-Leistungssteuerungsschaltung nach Anspruch 1, **dadurch gekennzeichnet, dass** das Signal am Ausgang des logarithmischen Hüllkurvendetektors an einen ersten Multiplizierer geliefert wird, um es für einen ersten Gewichtungskoeffizienten zu multiplizieren, bevor es an den Addierer gekoppelt wird.

3. Hochfrequenz-Leistungssteuerungsschaltung nach Anspruch 1, **dadurch gekennzeichnet, dass** das Signal am Ausgang des Amplitudendetektors an einen zweiten Multiplizierer geliefert wird, um es für einen zweiten Gewichtungskoeffizienten zu multiplizieren, bevor es an den Addierer gekoppelt wird.

4. Hochfrequenz-Leistungssteuerungsschaltung nach Anspruch 1, **dadurch gekennzeichnet, dass** das Signal am Ausgang des Addierers an einen dritten Multiplizierer geliefert wird, um es für einen dritten Gewichtungskoeffizienten zu multiplizieren, bevor es an die Steuerungsvorrichtung gekoppelt wird.

5. Hochfrequenz-Leistungssteuerungsschaltung nach den Ansprüchen 2, 3, und 4, **dadurch gekennzeichnet, dass** ein Speicher zum Speichern des ersten, des zweiten und des dritten Koeffizienten vorgesehen ist.

6. Hochfrequenz-Leistungssteuerungsschaltung nach Anspruch 1, **dadurch gekennzeichnet, dass** der logarithmische Hüllkurvendetektor einen logarithmischen Verstärker und einen zweiten Hüllkurvendetektor umfasst.

7. Hochfrequenz-Leistungssteuerungsschaltung nach Anspruch 1, **dadurch gekennzeichnet, dass** die Steuerungsvorrichtung mit einem Eingangsanschluss zum Empfangen der notwendigen Daten zum Erhalten der gewünschten Ausgangsleistung ausgerüstet ist.

## Revendications

1. Circuit de commande de puissance de signal radiofréquence comportant :
une chaîne d'amplificateurs à gain variable (11) pour délivrer une puissance à radiofréquence modulée ;
un détecteur d'amplitude (14) couplé à ladite chaîne d'amplificateurs à gain variable (11) ;
un dispositif contrôleur (22) recevant un signal détecté provenant dudit détecteur d'amplitude (14) et réglant le gain de ladite chaîne d'amplificateurs à gain variable (11) ;
**caractérisé en ce que**
ledit détecteur d'amplitude (14) délivre ledit signal détecté à un filtre passe bande (15) ;
le signal à la sortie dudit filtre passe bande est délivré à un détecteur d'enveloppe logarithmique (16, 17) ;
le signal à la sortie dudit détecteur d'enveloppe logarithmique (16, 17) est couplé à un additionneur (20) ;
le signal à la sortie dudit détecteur d'amplitude (14) est couplé audit additionneur (20) ;
le signal à la sortie dudit additionneur (20) est couplé audit dispositif contrôleur (22).

2. Circuit de commande de puissance de signal radiofréquence selon la revendication 1, **caractérisé en ce que** ledit signal à la sortie dudit détecteur d'enveloppe logarithmique est délivré à un premier multiplicateur en vue de le multiplier par un premier coefficient de pondération, avant de le coupler audit additionneur.

3. Circuit de commande de puissance de signal radiofréquence selon la revendication 1, **caractérisé en ce que** ledit signal à la sortie dudit détecteur d'amplitude est délivré à un deuxième multiplicateur en vue de le multiplier par un deuxième coefficient de pondération, avant de le coupler audit additionneur.

4. Circuit de commande de puissance de signal radiofréquence selon la revendication 1, **caractérisé en ce que** ledit signal à la sortie dudit additionneur est délivré à un troisième multiplicateur en vue de le multiplier par un second coefficient de pondération, avant de le coupler audit dispositif contrôleur.

5. Circuit de commande de puissance de signal radiofréquence selon l'une quelconque des revendications 2, 3 et 4, **caractérisé en ce qu'**une mémoire est fournie pour stocker lesdits premier, deuxième et troisième coefficients.

6. Circuit de commande de puissance de signal radiofréquence selon la revendication 1, **caractérisé en ce que** ledit détecteur d'enveloppe logarithmique comporte un amplificateur logarithmique et un second détecteur d'enveloppe.

7. Circuit de commande de puissance de signal radiofréquence selon la revendication 1, **caractérisé en ce que** ledit dispositif contrôleur est délivré avec un port d'entrée en vue de recevoir les données nécessaires pour obtenir la puissance de sortie désirée.
